(19) **Europäisches Patentamt**

**European Patent Office**

**Office européen des brevets**

(11) **EP 1 617 509 A1**

(12) **EUROPEAN PATENT APPLICATION**
published in accordance with Art. 158(3) EPC

(43) Date of publication:
**18.01.2006 Bulletin 2006/03**

(51) Int Cl.:
*H01Q 1/44* (1968.09)     *H01Q 7/06* (1968.09)
*H01Q 1/32* (1968.09)     *E05B 65/20* (1968.09)
*B60R 25/00* (1968.09)

(21) Application number: **04727730.6**

(22) Date of filing: **15.04.2004**

(86) International application number:
**PCT/JP2004/005419**

(87) International publication number:
**WO 2004/095636 (04.11.2004 Gazette 2004/45)**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **22.04.2003 JP 2003116926**
**26.05.2003 JP 2003147788**

(71) Applicant: **AISIN SEIKI KABUSHIKI KAISHA Kariya-shi, Aichi-ken 448-8650 (JP)**

(72) Inventors:
• **TSUKAHARA, Makoto**
**Kariya-shi,**
**Aichi 448-0003 (JP)**
• **SAKAI, Toshihiko**
**5008212 (JP)**
• **YAGI, Wataru**
**Nagoya-shi,**
**Aichi 461-0025 (JP)**
• **IEDA, Kiyokazu**
**Chiryu-shi,**
**Aichi 472-0017 (JP)**
• **MARUYAMA, Kota**
**Toyoake-shi,**
**Aichi 470-1154 (JP)**

(74) Representative: **TBK-Patent**
**Bavariaring 4-6**
**80336 München (DE)**

(54) **ELECTROSTATIC CAPACITY TYPE SENSOR-CARRYING ANTENNA DEVICE**

(57) An antenna device 1 has an antenna unit 2 which includes an antenna core member 5 including a soft magnetic member 51 having conductivity and a conductor member 6 which is attached to the antenna core member 5. At least part of the antenna core member 5 (for example, a core sheet 50A) is a sensor electrode which is able to detect an object. The sensor electrode is used as a sensor electrode such as a capacitance-operated sensor electrode. Thus, it is possible to provide an antenna device and a door handgrip apparatus having an antenna unit including an antenna core member which is shared for an antenna function and a sensor function.

FIG. 1

**EP 1 617 509 A1**

**Description**

TECHNICAL FIELD

The present invention relates to an antenna device and a door handgrip apparatus.

BACKGROUND ART

A door handgrip having a bar antenna unit is disclosed in Patent Document 1. According to this technology, the antenna unit is integrated in a handgrip body of the door handgrip. According to this technology, when a user who has an electronic key approaches the door handgrip, the door handgrip is brought into a receiving state, so that the bar antenna unit can receive an ID code transmitted from the electronic key.

In Patent Document 2, a door handgrip having a transmission antenna is disclosed. According to this technology, a transmission antenna unit is integrated in a handgrip body of the door handgrip. According to this technology, transmission is performed from the transmission antenna unit.

In Patent Document 3 and Patent Document 4, a door-opening and closing device in which a transmission antenna unit and a capacitance-operated sensor electrode are mounted separately in a door handgrip is disclosed. According to Patent Document 3 and Patent Document 4, the transmission antenna and the capacitance-operated sensor electrode are mounted separately, and hence the transmission antenna unit and the capacitance-operated sensor electrode are formed of separate members although they have a greater value-added. Therefore, the antenna unit demonstrates only a function as an antenna, and the sensor electrode demonstrates only a function as a capacitance-operated sensor. Therefore, disposing both of the antenna device and the sensor electrode separately requires larger internal capacity. For example, when they are used in the door handgrip, the design of the door handgrip may be limited.

Furthermore, Patent Document 5 discloses a door opening-closing apparatus for a vehicle. This door opening-closing apparatus includes a door handle for opening and closing the door, and an antenna and a sensor electrode are disposed in the door handle. Patent Document 6 discloses a plate-shaped sensor electrode having a U-shape in order to increase emission characteristics. Patent Document 6 also discloses an antenna integrated in a door handle employing a ferrite having soft magnetism as a core of the bar antenna. Furthermore, Patent Document 7 discloses a human body approach detection sensor for a motor vehicle having cable electrodes disposed in parallel.

In the door opening and closing device disclosed in Patent Document 6 and in the human body approach detection sensor for a motor vehicle disclosed in Patent Document 7, the above-described antenna device and the sensor are separate members, and are disposed separately. Accordingly, each of the antenna device and the sensor electrode only has its own function, and hence the antenna demonstrates only the function as the antenna and the sensor electrode demonstrates only the capacitance-operated sensor function, although they have a greater value-added. Therefore, disposing both of the antenna device and the sensor electrode separately requires larger internal capacity. For example, when they are used in the door handgrip, the design of the door handgrip may be limited.

As disclosed in Patent Document 6, when the sensor for detecting the approach of the human body by variations in capacitance is disposed near the antenna device, emission of electric wave from the antenna device is limited. Therefore, in Patent Document 6, by disposing the sensor electrode of substantially U-shape, area of the antenna device blocked by the sensor electrode is reduced to prevent interception of electric wave, thereby solving the problem. However, in order to increase variations in capacitance in the sensor electrode, it is necessary to increase the area of the sensor electrode, and increase in the area of the sensor electrode induces upsizing.

[Patent Document 1] Japanese Unexamined Patent Application Publication No. 2001-355358
[Patent Document 2] Japanese Unexamined Patent Application Publication No. 2000-160897
[Patent Document 3] Japanese Unexamined Patent Application Publication No. 2002-295064
[Patent Document 4] Japanese Unexamined Patent Application Publication No. 2003-13628
[Patent Document 5] Japanese Unexamined Patent Application Publication No. 2002-30844
[Patent Document 6] Japanese Unexamined Patent Application Publication No. 2001-345615
[Patent Document 7] Japanese Unexamined Patent Application Publication No. 10-308149

DISCLOSURE OF THE INVENTION

The present invention is a further improved technology of the related art described above, and is intended to provide an antenna device with a sensor and a door handgrip apparatus which includes an antenna core member which is shared for an antenna function and a sensor function, and is advantageous for installing in a narrow space.

An antenna device according to a first aspect is an antenna device provided with an antenna unit having an antenna core member with a soft magnetic member and a conductor member attached to the antenna core member,

characterized in that a conductive layer is arranged on at least part of the antenna core member and the conductive layer is a sensor electrode.

According to the antenna device as described above, the antenna unit includes the antenna core member and the conductor member attached to the antenna core member, so as to be capable of transmission and/or reception. In addition, at least part of the antenna core member has a conductive layer and the conductive layer is the sensor electrode. Therefore, when an object exists on or approaches the sensor electrode, the existence or approach thereof is detected. In other words, the soft magnetic member which constitutes the antenna core member of the antenna unit is shared both for the antenna function and the sensor function.

For example, when the sensor electrode is used as the capacitance-operated sensor electrode, since the capacitance to be detected via the sensor electrode varies with approach of the object to the sensor electrode, the existence or approach of the object is detected. Alternatively, when the object which has conductivity such as a water drop is attached to the sensor electrode, a physical quantity such as an electric resistance varies via the sensor electrode, and hence the existence of the object can also be detected. In this manner, application as a sensor other than the capacitance-operated sensor is also conceivable.

In addition, since the antenna device is the device including the antenna unit having the antenna function and the sensor electrode having the sensor function integrally, space saving is achieved. Accordingly, the antenna device can be disposed in a small space.

A door handgrip apparatus according to a second aspect is a door handgrip apparatus including an antenna device provided with an antenna unit having an antenna core member and a conductor member attached to the antenna core member, and a handgrip for holding the antenna device, characterized in that a conductive layer is arranged at least part of the antenna core member of the antenna device, and the conductive layer is a sensor electrode. According to the door handgrip apparatus, the antenna unit includes the antenna core member and the conductor member attached to the antenna core member, and hence transmission and/or reception is possible. In addition, at least part of the antenna core member includes the conductive layer, and the conductive layer is the sensor electrode. Therefore, when an object exists on or approaches the sensor electrode of the door handgrip apparatus, physical quantity such as capacitance varies, and the existence or approach of the object is detected. In other words, the soft magnetic member which constitutes the antenna core member of the antenna unit is shared for the antenna function and the sensor function.

As described above, according to the antenna device of the first aspect and the door handgrip apparatus of the second aspect, the antenna core member of the antenna unit has both the antenna function and the sensor function. Therefore, the antenna device with a sensor and the door handgrip apparatus which can function both as an antenna and an electrode sensor can be provided. The antenna device according to the present invention is a device including the antenna device having the antenna function and the sensor electrode having the sensor function integrated therein, and hence the space saving is achieved. Accordingly, it can be disposed in a small space.

BRIEF DESCRIPTION OF THE DRAWINGS

Fig. 1 is a perspective view showing a concept of an antenna device with a sensor according to a first embodiment.
Fig. 2 is a perspective view showing a concept of the antenna device with a sensor according to a second embodiment.
Fig. 3 is a perspective view showing a concept of the antenna device with a sensor according to a third embodiment.
Fig. 4 is a graph showing a relation between an operating time of the antenna and an operating time of the sensor according to a fourth embodiment.
Fig. 5 is a side view of a door handgrip apparatus having the antenna device with a sensor according to a fifth embodiment.
Fig. 6 is a cross-sectional view of a principal portion of the door handgrip apparatus according to the fifth embodiment.
Fig. 7 is a cross-sectional view of a principal portion of the door handgrip apparatus according to the fifth embodiment taken along a different direction.
Fig. 8 is a cross-sectional view of a principal portion of the door handgrip apparatus according to a sixth embodiment taken along a different direction.
Fig. 9 is a perspective view of an antenna core member having a conductive layer according to a seventh embodiment.
Fig. 10 is a cross sectional view of the antenna core member having the conductive layer with a conductor member wound around the outside thereof according to the seventh embodiment.
Fig. 11 is a perspective view showing a concept of the antenna device with a sensor according to the seventh embodiment.
Fig. 12 is a graph showing the relation between the operating time of the antenna and the operating time of the sensor according to the seventh embodiment.
Fig. 13 is a perspective view showing the antenna core member having the conductive layer according to an eighth embodiment.

Fig. 14 is a cross-sectional view of the antenna core member having the conductive layer which is faced in opposite directions from each other wound outside thereof according to a ninth embodiment.

Fig. 15 is a plan view showing a concept of the antenna device with a sensor according to a tenth embodiment.

Fig. 16 is a cross-sectional view showing a concept of the door handgrip apparatus being provided on a vehicle body and having the antenna device with a sensor integrated therein according to an eleventh embodiment.

Fig. 17 is a front view of the door handgrip apparatus according to a first application.

Fig. 18 is a cross-sectional view of the door handgrip, viewed in the direction along a line W18-W18 in Fig. 17 according to the first application.

Fig. 19 is a block diagram showing a state in which a user holding the door handgrip apparatus provided on an architectural structure opens and closes the door according to a second application.

Fig. 20 is a block diagram of the door handgrip apparatus provided on the architectural structure according to the second application.

Fig. 21 is a block diagram of another door handgrip apparatus provided on the architectural structure according to the second application.

Fig. 22 is a block diagram applied to a defective article detection device in a factory according to a third application.

Fig. 23 is a block diagram applied to a substance detecting device in the factory according to a fourth application.

BEST MODE FOR CARRYING OUT THE INVENTION

An embodiment in which a capacitance-operated sensor electrode is preferably employed as a sensor electrode can be shown. In this case, when an object approaches the sensor electrode, capacitance varies, and hence existence of the object is detected. An embodiment in which a conductive sensor electrode is employed as a sensor electrode can be shown. In this case, when a conductive substance such as a water drop comes into contact with the sensor electrode, the sensor electrode is conducted via the conductive substance, and hence presence or absence of the conductive substance can be detected from variations in physical quantity such as electric resistance. In this manner, it can be applied to a sensor other than the capacitance-operated sensor.

According to the present invention, an antenna unit includes an antenna core member provided with a soft magnetic member, and a conductor member attached to the antenna core member. As soft magnetic materials forming the soft magnetic member, steel plate, silicon steel plate, amorphous soft magnetic material, soft magnetic nanocrystalline material which are superior in magnetic conductivity may be exemplified. Therefore, a core sheet can be formed of the steel plate, the silicon steel plate, the amorphous soft magnetic material, or the soft magnetic nanocrystalline material as the core sheet. In particular, the amorphous soft magnetic material or the soft magnetic nanocrystalline material has a high efficiency of magnetic transmission and a high frequency property while having conductivity.

As the amorphous soft magnetic material, iron based material and cobalt based material may be exemplified. As the soft magnetic nanocrystalline material, material including at least selected one of iron, cobalt, nickel, and at least selected one of titanium, zirconium, hafnium, vanadium, niobium, molybdenum, chrome, tungsten, tantalum, and manganese, and being based on ultra-micro crystal grains of 2000 Angstrom or smaller, 1000 Angstrom or smaller, 500 Angstrom or smaller in grain diameter may be exemplified. Depending on the cases, as soft magnetic material which forms the antenna core member may be a bulk member formed by curing soft magnetic powder. As the antenna core member, a form covered by a sealing film may be exemplified. In this case, even when the antenna core member is subjected to corrosion, protective properties and durability of the antenna core member can further be enhanced.

According to the present invention, the antenna core member is preferably formed by laminating a plurality of core sheets with deformable layers interposed between the adjacent core sheets. In this case, since the antenna core member is formed with the deformable layers interposed between the adjacent core sheets, even when an external load is applied thereto, the deformability of the core sheet is secured, and hence the protective properties of the core sheet is enhanced. As the deformable layer, soft material layer or air layer may be exemplified. As the soft material layer, a rubber-type member (rubber, soft resin or the like) may be exemplified. As the soft material layer, material having hard conductive properties or non-conductive properties may be exemplified.

According to the present invention, preferably, a form in which an opposing member provided so as to oppose the conductive layer for forming an entry space for allowing the object to enter between the opposing member and the conductive layer is provided may be employed. In this case, the conductive layer and the opposing member may be opposed directly with the intermediary of the entry space, or the conductive layer and the opposing layer may be opposed with another member interposed between the conductive layer and the opposing member.

The opposing member may be formed of material having conductivity. Preferably, the opposing member can be grounded (earthed). A base member on which the antenna device is mounted may be employed as the opposing member. When it is applied to a vehicle or a structure such as the architectural structure, a body (including a door body) of the structure such as the vehicle or the architectural structure or the like may be employed as the base member. The body of the vehicle body is generally grounded.

Preferably, a form including a controller which transmits or receives electrical signals with respect to the conductor member of the antenna unit may be employed. As the controller, a form in which the antenna operating time unit which transmits or receives the electrical signals with respect to the conductor member and the sensor operating time which supplies power to the sensor electrode are temporally shifted may be exemplified. This form is advantageous for reducing noise. To temporally shift the antenna operating time unit and the sensor operating time means that the antenna operating time unit and the sensor operating time do not completely temporally coincide, and the both parties may be overlapped partly as long as they are partly separated.

The antenna unit includes the conductor member attached to the antenna core member. A coil can be exemplified as a conductor member. In order to allow the antenna unit as the antenna, a structure in which the antenna core member is inserted into a coil-shaped conductor member may be employed. By supplying power to the coil-shaped conductor member, a magnetic flux corresponding to a current thereof is generated in the antenna core member, and a magnetic field is generated in the space, whereby the antenna unit becomes a transmission antenna. Alternatively, when it receives the electric signal, since a current corresponding to a magnetic field to be generated in the antenna core member is generated at the coil-shaped conductor member, the antenna unit becomes a reception antenna.

The shape of the antenna core member is not specifically limited, and a member of a plate shape, such as a square plate shape, or a member of a bar shape, such as a square bar or round bar shape may be exemplified. As the antenna core member, a form including iron oxide such as ferrite as a base material may be employed. The antenna core member is provided with a soft magnetic member having conductivity, and a form in which at least part of the soft magnetic member is conductive layer may be exemplified. In this case, the conductive layer may be formed of steel plate, silicon steel plate, amorphous soft magnetic material, soft magnetic nanocrystalline material which are superior in magnetic conductivity.

As the antenna core member, a form in which the ferrite is employed as a base material and the conductive layer is arranged at least part of a surface of the antenna core member may be exemplified. Any material may be employed as the material of the conductive layer as long as it has conductivity. As the material of the conductive layer, for example, at least one of nickel, nickel alloy, chrome, chrome alloy, aluminum, aluminum alloy, copper, copper alloy, titanium, and titanium alloy may be employed.

In order to reduce loss of the antenna unit, as the material which forms the conductive layer, a material having low conductivity and low magnetic permeability is preferable, and hence non-magnetic metal is preferable when considering Expression 1 described later. In addition, depending on the environment of operation, a material with high corrosion resistance is preferable.

As the conductive layer, a form of conductive film or foil may be employed. In the case of the film, the film may be formed on the surface of the antenna core member by film forming means such as vapor deposition, spattering, ion plating, electro-plating method, and so on. In the case of the foil, the foil can be bonded on the surface of the antenna core member via an adhesive agent. In the case of the foil, since the foil may be warped or deformed when it is separated from the antenna core member, it is necessary to provide foil holding means for holding the foil. However, when the foil is integrally adhered on the antenna core member, warping or deformation of the foil may be prevented and retentive properties of the foil can be enhanced. Therefore, reduction of thickness can be advantageously achieved, and reduction of loss of the antenna can be advantageously achieved.

The thickness of the conductive layer can be selected as needed depending on the magnetic permeability, the conductivity, of the conductive layer, and frequency of the electric wave to be used and, a thickness of, for example, 0.1 to 500 $\mu$m, 0.1 to 100 $\mu$m, 11 to 50 $\mu$m may be employed. Thicknesses of 0.2 $\mu$m, 0.5 $\mu$m, 1 $\mu$m, 2 $\mu$m may be exemplified as the lower limit of the thickness of the conductive layer, and thicknesses of 100 $\mu$m, 500 $\mu$m, 1000 $\mu$m may be exemplified as the upper limit of the thickness of the conductive layer. However, the thickness of the conductive layer is not limited thereto. A form in which the conductive layer is provided on the surface of the antenna core member may be exemplified.

When the thickness of the conductive layer is smaller than the thickness of a surface skin layer $\delta$ with respect to the electric wave of a frequency that the antenna tries to transmit or receive, the loss of the antenna can be reduced. Therefore, in order to reduce the loss of the antenna, it is preferable to determine the thickness of the surface skin layer $\delta$ as small as possible. The thickness of the surface skin layer $\delta$ means a distance whereby an electromagnetic field entered into a certain material is attenuated to 1/e (e $\approx$ 2.718). The thickness of the surface skin layer $\delta$ is expressed by the following Expression 1, where $\mu$ represents magnetic permeability, $\sigma$ represents conductivity ($\sigma = 1/\rho$), and $\omega$ represents angular frequency ($\omega=f/2\pi$, f represents frequency).

$$\delta = (2/\mu\sigma\omega)^{1/2} \ldots\ldots (\text{Expression 1})$$

Therefore, the lower the magnetic permeability $\mu$, the conductivity $\sigma$, and the frequency f are, the larger the thickness of the surface skin layer $\delta$ becomes. In contrast, the higher the magnetic permeability $\mu$, the conductivity $\sigma$, and the frequency f are, the smaller the thickness of the surface skin layer $\delta$ becomes. Therefore, when reduction of the loss of the antenna with the same thickness is desired, it is preferable to form the conductive layer of non-magnetic metal with low conductivity and high resistance.

When iron oxide such as ferrite is employed as a base material and the antenna core member is formed by sintering the compressed powder material of iron oxide powder, the antenna core member has minute projections and depressions on the surface thereof in many cases unless otherwise polished. When there exist minute projections and depressions on the surface of the antenna core member, such minute projections and depressions may easily be formed on the conductive layer laminated on the antenna core member correspondingly. This is advantageous for increasing a surface area of the conductive layer, and hence is advantageous for increasing an electrode area of the sensor electrode, thereby being advantageous for improving sensitivity of the sensor. The surface of the antenna core member can be polished as needed.

When the conductive layer is integrally laminated on the antenna core member, even when the antenna core member is damaged by any chance, an effect of the conductive layer which prevents excessive growing of cracks on the antenna core member may also be expected.

Also, a form in which the opposing member which is provided so as to oppose the conductive layer so as to form the entry space through which the object can be entered therethrough between the conductive layer and the opposing member can also be exemplified. The conductive layer and the opposing member may be opposed directly via the entry space, or the conductive layer and the opposing member may be opposed via the entry space with another member interposed between the conductive layer and the opposed member. The opposing member may be formed of material having conductivity. Preferably, the opposing member can be grounded (earthed). The base member to which the antenna device with a sensor is mounted may be used as the opposing member. When it is applied to a vehicle or a structure such as the architectural structure, the body (including the door body) of the structure such as the vehicle or the architectural structure or the like may be employed as the base member. The body of the vehicle body is generally grounded.

Preferably, a form including the controller which transmits or receives electrical signals with respect to the conductor member of the antenna core member may be employed. As the controller, a form in which the antenna operating time during which the electrical signals with respect to the conductor member is transmitted or received and the sensor operating time during which the conductive layer is used as the sensor electrode are temporally shifted may be exemplified. The form in which the antenna operating time and the sensor operating time are shifted as described above is advantageous for reducing noise. To temporally shift the antenna operating time and the sensor operating time means that the antenna operating time and the sensor operating time do not completely temporally coincide, and the both parties may be overlapped partly as long as they are partly separated.

The handgrip device is operated by a human body or by a hand or arm of a robot. As a representative handgrip device, the door handgrip apparatus (including a door handgrip and a door knob) may be exemplified. The system of rotation of the handgrip may be of a pulling system or of a pushing system. When it is applied to the handgrip device, the opposing member may be formed of the body of the structure such as the vehicle to which the handgrip device is mounted, or may be a separate member other than the body.

In particular, in the case of the apparatus in which the presence or absence of the approaching object is detected by variations in capacitance, the conductive film or the foil disposed on the surface of the antenna core member formed of ferrite or the like as an electrode for holding the capacitance may be employed as the conductive layer. The conductive layer serves as the sensor electrode. The sensor electrode whereof the surface area of the portion opposing the object is larger can have a larger capacitance and hence can detect easily. Therefore, it is preferable to provide a sensor electrode entirely on the surface to which the object approaches.

As regards the door handgrip apparatus, by the provision of the antenna device with a sensor having a capacitance-operated sensor electrode, it can be applied to a door lock/unlock system in which communication is established between a portable apparatus that a user carries and the door to authenticate the user by the portable apparatus. In this case, a so-called key-less entry device, in which when the door is unlocked when the fact that the user touches the door handgrip is detected and the door is locked when the user releases his/her hand from the door handgrip may be realized. The door handgrip is a portion whereof the design is important, and hence the device integrated therein is desirably as small as possible. Therefore, it is important to integrate the antenna device with a sensor electrode and the antenna device is required to be small and to have high detecting sensitivity and high antenna performance.

Embodiments

(First Embodiment)

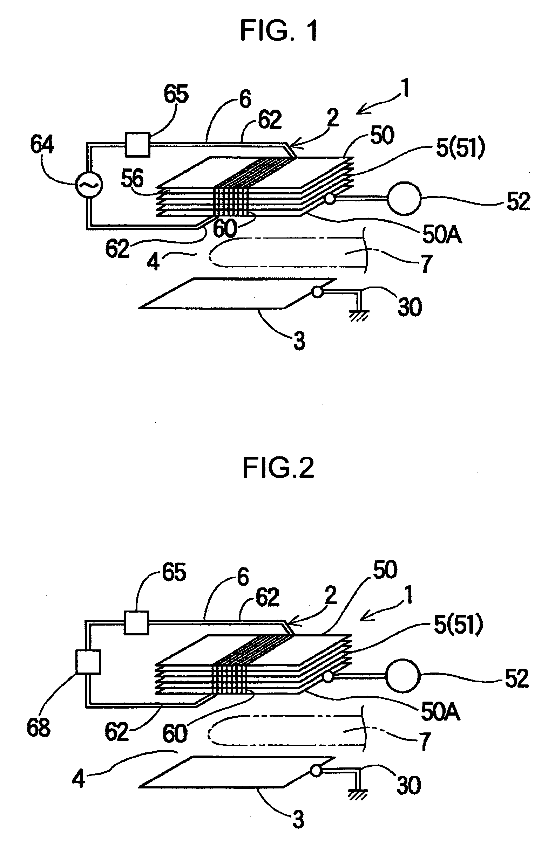

Referring now to Fig. 1, a first embodiment of the present invention will be described. An antenna device with a sensor 1 according to the present invention includes an antenna unit 2 for transmission. The antenna unit 2 includes an antenna core member 5 having magnetic permeability and a conductor member 6 attached to the antenna core member 5 as shown in Fig. 1.

In addition, the antenna device with a sensor 1 according to the present embodiment includes an opposing member 3 provided so as to oppose the antenna core member 5 to form an entry space 4 to allow an object 7 to enter therebetween. The opposing member 3 is formed into a plate shape of material having conductivity (for example, iron-based material, cobalt-based material, nickel-based material, aluminum-based material, and so on). The opposing member 3 opposes the antenna core member 5 via the entry space 4, and is grounded (earthed) via an earth cable 30. The opposing member 3 has a required surface area and is disposed along the antenna core member 5. The opposing member 3 can be formed of a base member (a body such as a door body in the case of a vehicle) for holding the antenna device with a sensor 1.

As shown in Fig. 1, the antenna core member 5 is good in magnetic permeability, and has conductivity. The antenna core member 5 is formed of soft magnetic members 51 having a laminated structure formed by laminating a plurality of core sheets 50 having conductivity and high magnetic permeability at intervals in the direction of the thickness thereof. Although the single core sheet 50 is thin, since the core sheets 50 are laminated to form the soft magnetic member 51 having a laminated structure, an appearance volume which functions as a magnetic core of the antenna unit 2 can be secured. With the soft magnetic member 51 having the laminated structure including laminated core sheets 50, when eddy current is generated in the core sheets 50, the size of the eddy current loop can be reduced in the direction of lamination of the core sheets 50, which is advantageous in reduction of eddy current loss. Although the thickness of the one single core sheet 50 can be selected as needed, when considering reduction of the eddy current loss in the high-frequency range, thicknesses of 1000 $\mu$m or less, in particular, 500 $\mu$m or less, 100 $\mu$m or less, and 50 $\mu$m or less can be exemplified, and a thickness of 0.01 $\mu$m can be exemplified as the lower limit of the thickness.

The entire antenna core member 5 or the surfaces of the respective core sheets 50 may be coated by a sealing film which is high in electric resistance and high in sealing property as needed. Accordingly, even when the operating environment is severe, durability of the entire antenna core member 5 or the respective core sheets 50 can be improved. In particular, the antenna core member 5 is protected from foreign substances (water, iron powder, carbon content, and so on) from the external field, so that durability of the function of the capacitance-operated sensor is effectively improved.

As a material of the core sheet 50, soft magnetic material with a low coercive force can be exemplified. As the soft magnetic material, amorphous soft magnetic material or soft magnetic nanocrystalline material can be exemplified. These materials are superior in magnetic permeability and high-frequency characteristics while retraining conductivity, and hence are advantageous for increasing the performance and reducing the size. As the amorphous soft magnetic material, iron-based material, cobalt-based material, and so on can be exemplified. As the soft magnetic nanocrystalline material, material including at least selected one of iron, cobalt, nickel, and at least selected one of titanium, zirconium, hafnium, vanadium, niobium, molybdenum, chrome, tungsten, tantalum, and manganese, and being based on ultra-micro crystal grains of 5000 Angstrom or smaller in grain diameter may be exemplified.

According to the present embodiment, the entire antenna core member 5 or the surfaces of the respective core sheets 50 may be coated by the sealing film which is high in electric resistance as needed. By coating the surfaces of the respective core sheets 50 with the film having high electric resistance, generation of the eddy current loop is constrained in the direction of the thickness of the core sheets 50, whereby the eddy current loss can be reduced. As the film having a large electric resistance, organic films or inorganic films may be employed and, for example, phosphoric acid-based film or ferrite iron oxide film may be employed.

According to the present embodiment, a deformable layer 56 is interposed between the core sheets 50 which constitute the soft magnetic member 51 of laminated structure which constitutes the antenna core member 5. When the deformable layer 56 is interposed between the core sheets 50, the deformation permissibility and the protective performances of the core sheets 50 can be enhanced. As the deformable layer 56, a soft material layer or an air layer may be exemplified. As the soft material layer, a rubber-type member (rubber, soft resin or the like) may be exemplified.

The conductor member 6 of the antenna unit 2 is attached to the soft magnetic member 51 of the laminated structure of the antenna core member 5. More specifically, as shown in Fig. 1, the conductor member 6 includes a coil member 60 being wound around the outer surface of the soft magnetic member 51 of the laminated structure which constitutes the antenna core member 5 by a plurality of number of times, and an extension member 62 electrically connected to the coil member 60. The coil member 60 is wound around core sheets 50A from the outside as described later. A power source 64 and a controller 65 are connected to the extension member 62 of the conductor member 6. As the power source 64, an AC power supply is preferable.

As shown in Fig. 1, the core sheet 50A out of the plurality of core sheets 50 which constitute the soft magnetic member 51 of the laminated structure, which opposes the opposing member 3, has conductivity in addition to the soft magnetic property, and hence serves as a conductive layer. The core sheet 50A can function as a capacitance-operated sensor electrode, and is electrically connected to a detecting unit 52 which detects the capacitance. The detecting unit 52 has a function to apply a voltage between the core sheet 50A and the opposing member 3 when detecting the capacitance, and detect the capacitance of the core sheet 50A as the capacitance-operated sensor electrode. In the detecting unit 52, the capacitance-operated sensor employs a principle of the capacitor, and can be measured a wide variety of dielectric materials such as metallic member or human body as measuring objects.

Since the core sheet 50A and the opposing member 3 have large surface areas, it is advantageous for securing the capacitance. The areas of the core sheet 50A and the opposing member 3 may be the same, or may be different, and what is essential is that the capacitance-operated sensor can be constituted.

When the object approaches the core sheet 50A which is the sensor electrode of the antenna core member 5, that is, when the object 7 enters into the entry space 4 formed between the core sheet 50A of the antenna core member 5 and the opposing member 3, the capacitance varies by being affected by the dielectric constant of the object 7, which is detected by the detecting unit 52. Therefore, based on the variations in capacitance, existence of the varied object 7 or whether the object 7 is good or not is judged. As the object 7, living bodies such as human bodies or animals, working robots, or substances such as articles and cards, or liquid such as rain water may be exemplified.

According to the present embodiment, the opposing member 3 grounded via the earth cable 30 is provided near the antenna core member 5. Then, the width of the space capacity of the entry space 4 formed between the core sheet 50A of the antenna core member 5 and the opposing member 3 is defined within a predetermined width. Since the object 7 having different relative dielectric constant from the entry space 4 is disposed within the entry space 4, the volumetric capacity of the object 7 occupied in the entry space 4 increases, and hence variations in dielectric constant can easily be secured, thereby improving sensing property as the capacitance-operated sensor.

The controller 65 has a function to cause the antenna unit 2 to emit the electric wave.

When using the controller, since AC current is supplied from the power source 64 to the conductor member 6 of the antenna unit 2, electromagnetic wave is formed by generated electric field and magnetic field, and is emitted from the antenna unit 2 as electric waves. When the object 7 (for example, a human body or a substance) provided with an electronic key or the like approaches in a state in which the electric wave is emitted from the antenna unit 2, the electronic key or the like receives the electric waves. Since the electric waves emitted from the electronic key or the like are received by a receiving device, not shown, the approach of the object 7 is detected. Then, based on the electric wave emitted from the electronic key or the like, the ID authentication (for example, authentication of the user, or object authentication such as the authentication of articles), that is, whether or not the object 7 is registered in advance, can be carried out.

Furthermore, since the capacitance varies when the object 7 approaches the core sheet 50A of the antenna core member 5, that is, when the object 7 enters the entry space 4, existence of the above-described object 7, or whether or not the object 7 is good or not is judged. Therefore, by effectively using the soft magnetic member 51 of the antenna core member 5 of the antenna unit 2 having conductivity and soft magnetic properties, the capacitance-operated sensor for detecting the human body or for detecting the substance is obtained.

Description of the case, for example, in which the antenna device with a sensor 1 according to the present embodiment is mounted to the door handgrip apparatus will be added. In this case, since the power is supplied to the conductor member 6 of the antenna unit 2 from the power source 64, the electric waves are emitted from the antenna unit 2. In this manner, when the user having the electronic key or the like approaches in a state in which the electric waves are emitted from the antenna unit 2, the electronic key or the like receives the electric waves emitted from the antenna unit 2. Furthermore, since the receiving device receives the electric waves emitted from the electronic key or the like, the approach of the user to the door handgrip apparatus is detected, and the ID authentication of the user is carried out. The ID authentication (authentication of the user) means to judge whether or not the user is registered in advance or not.

When the user is judged to be the registered user by the ID authentication, opening and closing of the door is enabled. In other words, when a finger tip of the user approaches the antenna core member 5 for operating the door handgrip, that is, when the finger tip of the user enters into the entry space 4, the capacitance in the entry space 4 varies, and hence the will of the user who wants to open or close the door is detected. Therefore, a door lock device, not shown, is activated to unlock the door device. When the user is not authenticated to be the registered user, even when the finger tip of the user approaches the antenna core member 5 to operate the door handgrip, the door device is maintained in a locked state. As described above, when the conditions such as the ID authentication by the antenna unit 2 based on the electric wave and detection of will of the user to open the door based on variations in capacitance are satisfied, the door handgrip apparatus is unlocked.

According to this embodiment, the core sheet 50A out of the plurality of core sheets 50 which constitute the soft magnetic member 51 of the laminated structure of the antenna core member 5, which opposes the opposing member 3, are electrically connected to the detecting unit 52 for detecting the capacitance. However, the invention is not limited thereto, and the core sheet 50 different from the core sheet 50A which constitute the soft magnetic member 51 of the laminated structure can be electrically connected to the detecting unit 52. In this case, the different core sheet 50 electrically connected to the detecting unit 52 serves as the sensor electrode.

Also, according to the present embodiment, the opposing member 3 which is grounded via the earth cable 30 is provided. However, the invention is not limited thereto, and the ground (earth) itself can be used instead of the opposing member 3.

(Second Embodiment)

Fig. 2 shows a second embodiment. The second embodiment has basically the same structure as the first embodiment. The parts having common functions are represented by the common reference numerals. Description will be made mainly on different parts. The antenna device with a sensor 1 according to the present embodiment has the antenna unit 2 for reception. The antenna unit 2 includes the antenna core member 5 and the conductor member 6 attached to the antenna core member 5 as shown in Fig. 2. The conductor member 6 of the antenna unit 2 is attached to the soft magnetic member 51 of laminated structure of the antenna core member 5. More specifically, as shown in Fig. 2, the conductor member 6 includes the coil member 60 wound around the antenna core member 5, and the extension member 62 electrically connected to the coil member 60. A wave detecting unit 68 and the controller 65 are connected to the extension member 62 of the conductor member 6.

When operating, the antenna unit 2 receives the electric waves from the outside. Therefore, when the object 7 (for example, human body or substance) provided with the electronic key or the like which transmits the electric waves approaches, the antenna unit 2 receives the electric waves and hence approach of the object 7 is detected. When the object 7 further approaches the core sheet 50A of the antenna core member 5, that is, when the object 7 enters into the entry space 4, the capacitance in the entry space 4 varies, and hence existence of the object 7 described above or whether the object 7 is good or not is judged.

(Third Embodiment)

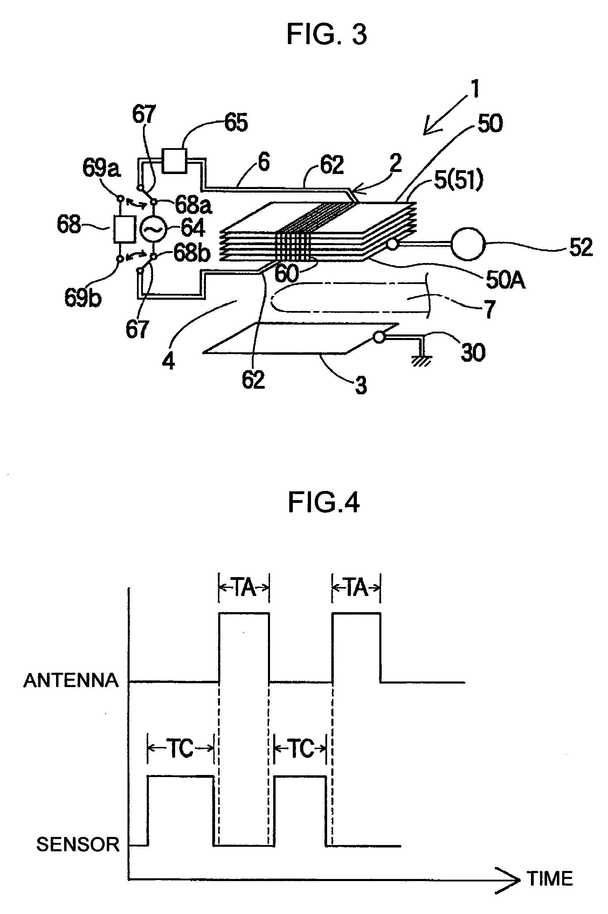

Fig. 3 shows a third embodiment. The third embodiment has basically the same structure as the first embodiment. The parts having common functions are represented by the common reference numerals. Description will be made mainly on different parts. The antenna device with a sensor 1 according to the present embodiment includes the antenna unit 2 for transmission and reception. As shown in Fig. 3, the antenna core member 5 and the conductor member 6 attached to the antenna core member 5 are provided. The conductor member 6 of the antenna unit 2 is attached to the antenna core member 5. More specifically, as shown in Fig. 3, the conductor member 6 includes the coil member 60 wound around the antenna core member 5 and the extension member 62 electrically connected to the coil member 60. The controller 65 is connected to the extension member 62, and the wave detecting unit 68 and the power source 64 are switchably connected by a switch 67. When the switch 67 conducts first contact points 68a, 68b, the conductor member 6 is electrically connected to the power source 64, and hence the antenna unit 2 transmits the electric wave. When the switch 67 conducts second contact points 69a, 69b, the conductor member 6 is electrically connected to the wave detecting unit 68, and hence the antenna unit 2 can receive the electric waves.

(Fourth Embodiment)

Fig. 4 shows a fourth embodiment. The fourth embodiment has basically the same structure as the first embodiment. The parts having common functions are represented by the common reference numerals. Description will be made mainly on different parts. According to the respective embodiments described above, as shown in Fig. 4, the controller 65 is set to temporally shift an antenna unit operating time TA during which the electrical signals with respect to the conductor member 6 of the antenna unit 2 is transmitted and received and a sensor operating time TC during which it is used as the capacitor sensor. In other words, as shown in Fig. 4, the antenna unit operating time TA during which the electrical signals with respect to the conductor member 6 of the antenna unit 2 are transmitted and received and the sensor operating time TC during which it is used as the capacitor sensor are carried out at different timings so as to avoid temporal overlapping. Therefore, when the antenna unit 2 demonstrates the antenna function, the capacitance-operated sensor is turned off. In contrast, when the antenna unit 2 functions as the capacitance-operated sensor, the antenna function is turned off. Accordingly, generation of noise is advantageously constrained. The antenna unit operating time TA for transmitting or receiving the electrical signals with respect to the conductor member 6 of the antenna unit 2 and the sensor operating time TC in which the opposing member 3 is used as the capacitor sensor may be performed completely separately or, depending on the cases, they may be temporally overlapped in part as long as there is an area which is not temporally overlapped.

(Fifth Embodiment)

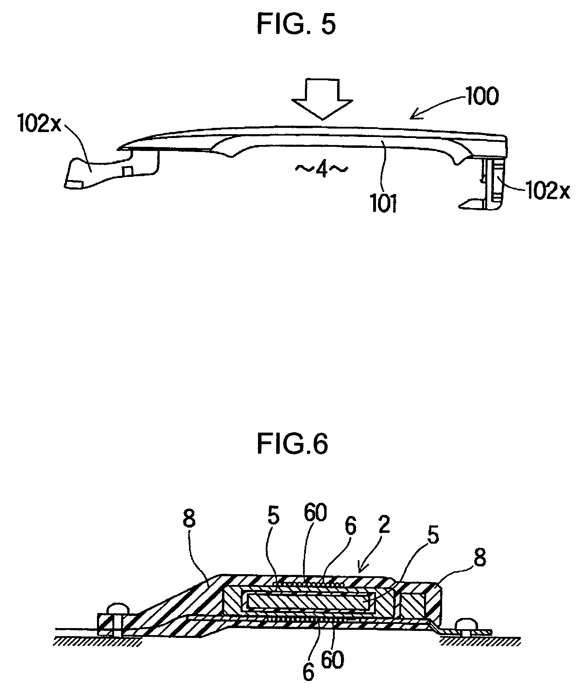

Fig. 5 to Fig. 7 show a fifth embodiment. The fifth embodiment has basically the same structure as the first embodiment. The parts having common functions are represented by the common reference numerals. Description will be made mainly on different parts. The present embodiment is applied to a door handgrip apparatus 100 mounted to the body of the vehicle for opening and closing the door. The door handgrip apparatus 100 includes a handgrip 101 operated by finger tips and a mounting arm 102x for mounting the handgrip 101 to the door body of the vehicle. The handgrip 101 defines the entry space 4 to which the finger tip enters with the door body. Inside the handgrip 101, the antenna unit 2 is disposed. When using, the antenna unit 2 transmits or receives the electric waves for performing ID authentication of the user as described above. Therefore, when the finger tip of the user as the object enters into the entry space 4 in a state in which the ID authentication of the user is performed, the capacitance in the entry space 4 is changed, and hence existence of the finger tip is determined and the will of the user to open the door is detected. Therefore, the door lock device, not shown, is activated to unlock the door device.

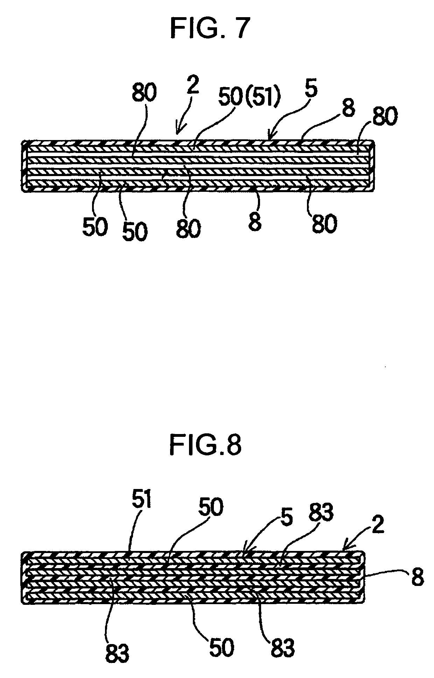

As shown in Fig. 6 and Fig. 7, the antenna core member 5 is configured by laminating the plurality of core sheets 50 at intervals in the direction of thickness. The entire antenna core member 5 is integrally embedded into a mold member 8 together with the coil member 60. Accordingly, excess moisture tolerance, resistance to shock, and flexibility of the core sheet 50 can be improved. Provided between the core sheets 50 are air layers 80 as the deformable layers. Therefore, the deformation admissibility of the core sheet 50 is secured, and even when a load of the external force is applied, the protective property is secured. The thickness and width of the air layers 80 can be reduced, and actually the core sheets 50 may be in contact with each other. Fig. 6 is a conceptual drawing and actually, the number of core sheets is larger than in the drawing.

(Sixth Embodiment)

Fig. 8 shows a sixth embodiment. The sixth embodiment has substantially the same structure as the first embodiment. The parts having common functions are represented by the common reference numerals. Description will be made mainly on different parts. As shown in Fig. 8, the entire antenna core member 5 is integrally embedded in the mold member 8 together with the coil member 60, and provided between the core sheets 50 are soft material layers 83 as deformable layers. The soft material layers 83 are integrally provided with the mold member 8, and join the core sheets 50. Therefore, the deformation admissibility of the core sheets 50 is secured, and even when the load of the external force is applied, the protective properties of the antenna core member 5 are secured. The soft material layer 83 may be formed of rubber or soft resin, and urethane-based material, epoxy-based material, and silicone based material can be exemplified. Fig. 8 is a conceptual drawing and actually, the number of core sheets 50 is larger than in the drawing.

(Seventh Embodiment)

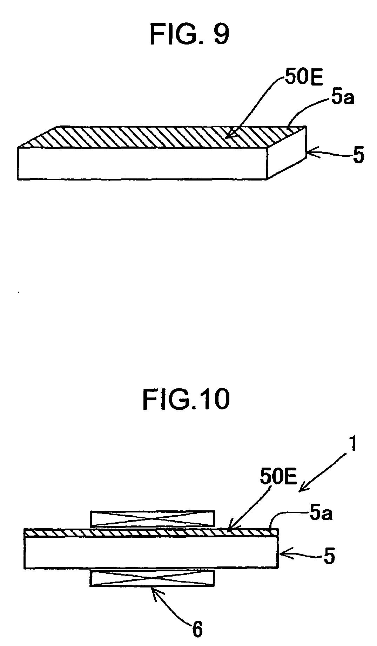

Referring now to Fig. 9 to Fig. 12, a seventh embodiment of the present invention will be described. Fig. 9 shows the antenna core member 5. The antenna core member 5 is formed of oxide-based soft magnetic material, more specifically, ferrite as iron oxide, as a base material, and is obtained by sintering the compressed iron oxide powder material. Since the ferrite is formed of iron oxide material, cost of the raw material is low, and may be formed into various shapes by molding. Cu-Zn ferrite, Ni-Zn ferrite, Cu-Zn-Mg ferrite, Mn-Zn ferrite can be used as ferrite. Among others, ferrite other than Mn-Zn ferrite generally has a resistivity $\rho$ of $10^4$ $\Omega$cm or higher, and is a material having high electric resistivity and low conductivity. The resistivity $\rho$ of the Mn-Zn ferrite is generally 1 to $10^3$ $\Omega$cm, that is, it is relatively low in electric resistivity.

Then, a surface 5a of the antenna core member 5 of square plate shape is formed with a metallic film laminated by a film forming method such as spattering, vacuum deposition, electro-plating method, or the like, so that this metallic film serves as a conductive layer 50E (sensor electrode). The thickness of the conductive layer 50E is between 0.1 to 0.4 $\mu$m. The conductive layer 50E may be formed of metal such as Ni-Cr, or Ni-Cr-Si. For example, the conductive layer 50E may be formed of metal such as Ni-80 at.%Cr or Ni-50at.%Cr-5at.%Si. Consequently, as shown in Fig. 9, the conductive layer 50E can be formed entirely on the surface 5a of one of the antenna core members 5 formed of ferrite. The surface 5a is rectangular.

The thickness of the conductive layer 50E formed of metallic film is set to the same thickness as, or to a thickness smaller than, the thickness $\delta$ of the surface skin layer obtained by Expression 1 described above, and antenna loss is reduced. In this embodiment as well, it is also possible, not only to form the thin-film conductive layer 50E directly on the surface 5a of the antenna core member 5, but also to adhere the metallic foil on the surface 5a of the antenna core member 5 as the conductive layer 50E by adhesive agent or the like to obtain the conductive layer 50E.

When the conductive layer 50E formed of metallic film, metallic foil, or the like is used as the sensor electrode for detecting variations in capacitance in association with approach of the object, the capacitance of the sensor electrode is basically proportional to the electrode area of the sensor electrode and the dielectric constant of the object, and is in reverse proportion to the distance from the object. Therefore, using the variations in capacitance, the capacitance-operated sensor which detects presence or absence of the object in a certain range may be obtained. In this manner, in order to obtain the capacitance-operated sensor, the larger surface area of the sensor electrode formed of the conductive layer 50E results in higher detection sensitivity. Therefore, preferably, the conductive layer 50E formed of the metallic film or the metallic foil is disposed so as to cover the surface 5a of the antenna core member 5, which corresponds to a detection surface.

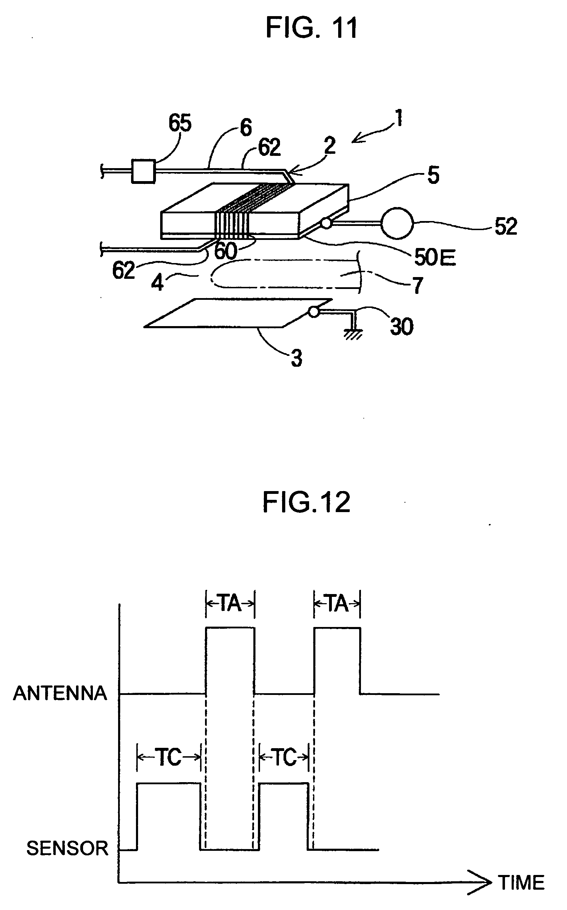

Fig. 10 shows a cross sectional view of a state in which the coil-shaped conductor member 6 is attached by winding solenoid coil around the antenna core member 5 provided with the conductive layer 50E. Fig. 10 schematically shows the antenna device with a sensor 1 to which the antenna core member 5 described above is applied. As shown in Fig. 11, the antenna device with a sensor 1 includes the antenna unit 2. The antenna unit 2 includes a bulk-shaped antenna core member 5 formed of ferrite having magnetic permeability and a coil-shaped conductor member 6 attached to the antenna core member 5.

The conductor member 6 of the antenna unit 2 is attached to the antenna core member 5. More specifically, the conductor member 6 includes the coil member 60 wound around the outer surface of the antenna core member 5 by a plurality of times in a coil shape, and the extension member 62 electrically connected to the coil member 60. The controller 65 is connected to the extension member 62 of the conductor member 6. As shown in Fig. 11, the antenna device with a sensor 1 according to the present embodiment includes the opposing member 3 disposed so as to oppose the conductive layer 50E of the antenna core member 5 so as to form the entry space 4 where the object 7 can enter with the antenna core member 5. The opposing member 3 is formed into a plate shape of material having conductivity (for example, iron-based material, cobalt-based material, nickel-based material, aluminum based material, and so on). The opposing member 3 opposes the conductive layer 50E of the antenna core member 5 via the entry space 4, and is grounded (earthed) via the earth cable 30. The opposing member 3 has a required surface area and is disposed along the antenna core member 5. The opposing member 3 can be formed of the base member (the body such as the door body in the case of the vehicle) for holding the antenna device with a sensor 1.

As shown in Fig. 11, the conductive layer 50E laminated on the antenna core member 5 has conductivity so as to be able to function as the capacitance-operated sensor electrode, and is electrically connected to the detecting unit 52 of for detecting the capacitance. The detecting unit 52 has the function to apply a voltage between the conductive layer 50E and the opposing member 3 when detecting the capacitance, and detect the capacitance of the conductive layer 50E as the capacitance-operated sensor electrode. In the detecting unit 52, the capacitance-operated sensor employs the principle of the capacitor, and can be measured a wide variety of dielectric materials such as the metallic member or human body as the measuring objects. Since the conductive layer 50E and the opposing member 3 have large areas, it is advantageous for securing the capacitance. The areas of the conductive layer 50E and the opposing member 3 may be the same, or may be different, and what is essential is that the capacitance-operated sensor can be constituted.

When the object approaches the conductive layer 50E which is the sensor electrode of the antenna core member 5, that is, when the object 7 enters into the entry space 4 formed between the conductive layer 50E of the antenna core member 5 and the opposing member 3, the capacitance varies by being affected by the dielectric constant of the object 7, which is detected by the detecting unit 52. Therefore, based on the variations in capacitance, the existence of the varied object 7 or whether the object 7 is good or not is judged. As the object 7, living bodies such as human bodies or animals, working robots, or substances such as articles and cards, or liquid such as rain water may be exemplified.

According to the present embodiment, the opposing member 3 grounded via the earth cable 30 is provided near the antenna core member 5. Then, the width of the space capacity of the entry space 4 formed between the conductive layer 50E of the antenna core member 5 and the opposing member 3 is defined within the predetermined width. Since the object 7 having different relative dielectric constant from the entry space 4 is disposed within the entry space 4, the volumetric capacity of the object 7 occupied in the entry space 4 increases, and hence the variations in dielectric constant can easily be secured, thereby improving the sensing property as the capacitance-operated sensor.

When using, since a current is supplied to the conductor member 6 of the antenna unit 2, the electromagnetic wave is formed by the generated electric field and the magnetic field, and is emitted from the antenna unit 2 as electric waves. When the object 7 provided with the electronic key or the like approaches in the state in which the electric wave is emitted from the antenna unit 2, the electronic key or the like receives the electric waves. Since the electric waves emitted from the electronic key or the like are received by the receiving device, not shown, the approach of the object 7 is detected. Then, based on the electric wave emitted from the electronic key or the like, the ID authentication whether or not the object 7 is registered in advance (for example, authentication of the user, or object authentication such as the authentication of articles) can be carried out. The ID authentication (user authentication) means to judge whether or not the user is registered in advance.

Furthermore, since the capacitance varies when the object 7 approaches the conductive layer 50E of the antenna core member 5, that is, when the object 7 enters the entry space 4, the existence of the above-described object 7, or whether or not the object 7 is good or not is judged. Therefore, by effectively using the conductive layer 50E laminated on the antenna core member 5 of the antenna unit 2, the capacitance-operated sensor for detecting the human body or for detecting the substance is obtained.

Description of the case, for example, in which the antenna device with a sensor 1 is mounted to the door handgrip apparatus will be added. In this case, since the power is supplied to the conductor member 6 of the antenna unit 2, the electric waves are emitted from the antenna unit 2. In this manner, when the user having the electronic key or the like approaches in the state in which the electric waves are emitted from the antenna unit 2, the electronic key or the like receives the electric waves emitted from the antenna unit 2. Furthermore, since the receiving device receives the electric waves emitted from the electronic key or the like, the approach of the user to the door handgrip apparatus is detected, and the ID authentication of the user is carried out. When the user is judged to be the registered user by the ID authentication, the opening and closing of the door is enabled as shown below. In other words, when the finger tip of the user approaches the antenna core member 5 for operating the door handgrip, that is, when the finger tip of the user enters into the entry space 4, the capacitance in the entry space 4 varies, and hence the will of the user who wants to open or close the door is detected. Therefore, the door lock device, not shown, is activated to unlock the door device. When the user is not authenticated to be the registered user, even when the finger tip of the user approaches the antenna core member 5 to operate the door handgrip, the door device is maintained in the locked state. As described above, when the conditions such as the ID authentication by the antenna unit 2 based on the electric wave and detection of the will of the user to open the door based on variations in capacitance are satisfied, the door handgrip apparatus is unlocked.

According to the embodiment described above, as shown in Fig. 12, the controller 65 is set to temporally shift the antenna unit operating time TA during which the electrical signals with respect to the conductor member 6 of the antenna unit 2 are transmitted and received and the sensor operating time TC during which the opposing member 3 is used as the capacitor sensor. In other words, as shown in Fig. 12, the antenna unit operating time TA during which the electrical signals with respect to the conductor member 6 of the antenna unit 2 are transmitted and received and the sensor operating time TC during which power is supplied to the opposing member 3 are set to different timings so as to avoid temporal overlapping. Therefore, when the antenna unit 2 demonstrates the antenna function, the capacitance-operated sensor is turned off. In contrast, when the antenna unit 2 functions as the capacitance-operated sensor, the antenna function is turned off. Accordingly, the generation of the noise is advantageously constrained. The antenna unit operating time TA during which the electrical signals with respect to the conductor member 6 of the antenna unit 2 are transmitted and received and the sensor operating time TC during which the opposing member 3 is used as the capacitor sensor may be performed completely separately. Alternatively, depending on the cases, they may be temporally overlapped in part as long as there is an area which is not temporally overlapped. According to this embodiment, while the opposing member 3 which is grounded via the earth cable 30 is provided, the invention is not limited thereto, and the ground (earth) itself can be used instead of the opposing member 3.

(Test Examples)

Based on the first embodiment described above, a test example 1 and a test example 2 were conducted as shown below.

(Test Example 1) Ni-Zn ferrite was used as ferrite which constitutes the bulk-shaped antenna core member 5. This ferrite is polished after sintering, and had dimensions of 3 mm in height, 5 mm in width, and 60 mm in length. The conductive layer 50E formed of metallic film was disposed on the rectangular-shaped side of 5 mm in width and 60 mm in length of the antenna core member 5. In this case, the film was formed by using a target having a composition of Ni-50at.%Cr-5at.%Si by spattering. At the time of film formation, the thickness of the conductive layer 50E was obtained by measuring the thickness of the film formed on a glass substrate placed near the antenna core member 5. The thickness of the conductive layer 50E was 0.40 $\mu$m. The electrical resistivity of the conductive layer 50E was 80 $\mu\Omega$cm. Although the projections and depressions of 0.40 $\mu$m or larger existed on the surface of the antenna core member 5 formed of ferrite, it functioned as the capacitance sensor without problem. As the antenna, when a current of 134 KHz was flowed to the coil-shaped conductor member 6, the electric field strength of 87dB$\mu$V/m at a position 3 m apart from the antenna core member 5, which was completely the same as the case of the antenna device formed of ferrite which is not provided with the conductive layer as the sensor electrode.

(Test Example 2) Ni-Zn ferrite was used as the ferrite to form the bulk-shaped antenna core member 5. The ferrite was polished after sintering and had dimensions of 3 mm in height, 5 mm in width, and 60 mm in length. The conductive layer 50E formed of metallic film was disposed on the both rectangular-shaped sides of 5 mm in width and 60 mm in length of the antenna core member 5. In this case, the film was formed by using a target having the composition of Ni-50at.%Cr-5at.%Si by spattering. At the time of film formation, the thickness of the conductive layer 50E was obtained by measuring the thickness of the film formed on the glass substrate placed near the antenna core member 5. The thickness of the conductive layer 50E was 0.40 μm on both surfaces of the antenna core member 5, and the electrical resistivity was 80 μΩcm. Although the projections and depressions of 0.40 μm or larger existed on the surface of the antenna core member 5 formed of ferrite, the both surfaces functioned as the capacitance sensor without problem. As the antenna, when a current of 134 KHz was flowed to the coil-shaped conductor member 6, the electric field strength of 87dBμV/m at a position 3 m apart from the antenna core member 5, which was completely the same as the case of the antenna device which is not provided with the conductive layer 50E as the sensor electrode.

(Eighth Embodiment)

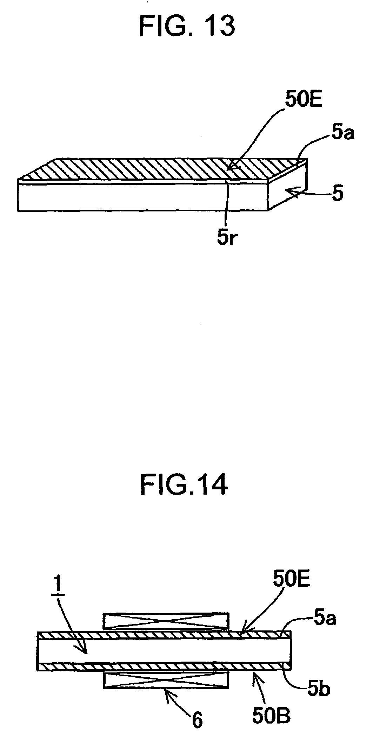

Fig. 13 shows an eighth embodiment. The eighth embodiment has basically the same structure as the first embodiment. The parts having common functions are represented by the common reference numerals. Description will be made mainly on different parts. When the bulk-shaped antenna core member 5 is formed of soft magnetic material having low electric resistivity as Mn-Zn ferrite or the like, as shown in Fig. 13, an insulating layer 5r formed of an insulating material can be formed on the surface 5a of the antenna core member 5 to form the conductive layer 50E on the insulating layer 5r. In this case, since the conductive layer 50E is insulated by the insulating layer 5r, the function of the sensor electrode formed of the conductive layer 50E can be preferably secured.

(Ninth Embodiment)

Fig. 14 shows a ninth embodiment. The ninth embodiment has the same structure and effects as the first embodiment. Description will be made mainly on parts different from the first embodiment. According to this embodiment, as shown in Fig. 14, the conductive layer 50E was integrally laminated on the surface 5a of the antenna core member 5. A conductive layer 50B is integrally laminated on a surface 5b facing the opposite direction from the surface 5a. The conductive layers 50E and 50B face the opposite direction from each other, and the coil-shaped conductor member 6 was wound around the conductive layers 50E, 50B. The two conductive layers 50E, 50B can be used as the sensor electrodes. Here, each of the conductive layers 50E, 50B may form the capacitance-operated sensor independently. Alternatively, the conductive layers 50E, 50B may be electrically connected to form a common capacitance-operated sensor.

(Tenth Embodiment)

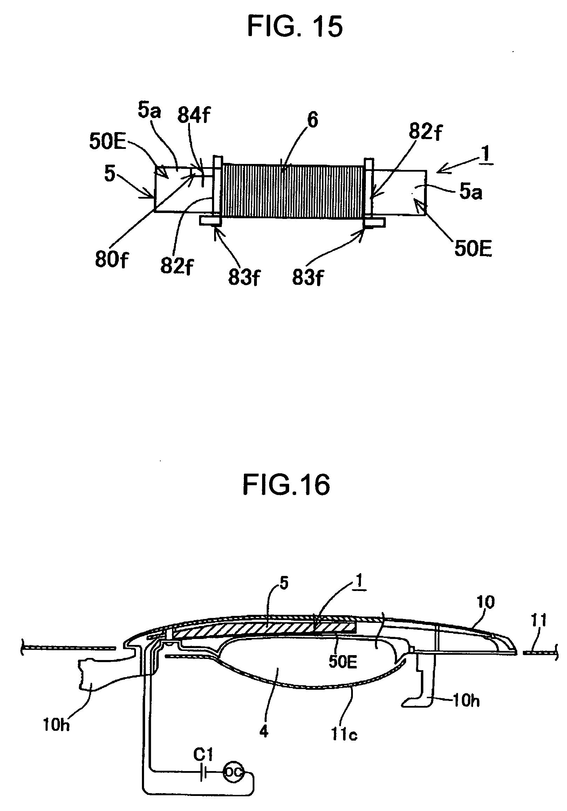

Fig. 15 shows a tenth embodiment. The tenth embodiment has basically the same structure and the same effects as the first embodiment. Description will be made mainly on parts different from the first embodiment. As shown in Fig. 15, the antenna device 1 employing the antenna core member 5 with the conductive layer 50E laminated on the entire surface 5a is provided. As shown in Fig. 15, the antenna core member 5 formed of ferrite has the conductive layer 50E formed of metallic thin film only on a surface 1a. A sensor terminal 80f is adhered on the surface of the conductive layer 50E, and the conductive layer 50E and the sensor terminal 80f are connected by an aluminum wire having a diameter of 100 μm, by so called wire bonding method. The method of bonding is not limited to the wire bonding method, and the terminal 80f may be connected by a method of mounting to the antenna core member 5 using a conductive adhesive agent depending on the operating environment. Furthermore, in order to wind the coil-shaped conductor member 6 around the outer periphery of the antenna core member 5, a resin bobbin 82f may be mounted to the antenna core member 5, and the coil-shaped conductor member 6 around the bobbin 82f. Here, the coil terminals 83f are provided on both sides of the resin bobbin 82f, which attaches the ends of the coil-shaped conductor member 6 to the resin bobbin 82f. Variations in capacitance of the conductive layer 50E which serves as the sensor electrode is detected via the sensor terminal 80f and a sensor connecting wire 84f. The antenna is configured in such a manner that a current is induced in the coil-shaped conductor member 6 by an electric wave received by the antenna core member 5, which is amplified in an amplifier via the coil terminal 83f in the case of reception. In the case of transmission, the transmission signals are provided to the coil-shaped conductor member 6 via the coil terminal 83f, and the electric wave is generated in the external field according to the magnetic flux density generated in the antenna core member 5.

(Eleventh Embodiment)

Fig. 16 shows an eleventh embodiment. The eleventh embodiment has basically the same structure and the same effects as the first embodiment. Description will be made mainly on parts different from the first embodiment. As shown in Fig. 16, a handgrip body 10 has an engaging element 10h, so that the handgrip body 10 is mounted to a body 11 by engaging the engaging element 10h with the body 11 of the vehicle such as the motor vehicle. The handgrip body 10 is formed of resin as a base material, and does not intercept emission of the electric waves. As shown in Fig. 16, the antenna device with a sensor 1 is integrated in the handgrip body 10 of the door handle of the vehicle. The body 11 of the vehicle is formed of metal having conductivity, and is grounded. The conductive layer 50E of the antenna device with a sensor 1 opposes a body surface 11c of the body 11 and forms the entry space 4. Therefore, when the finger tip of the user hold the handgrip body 10, the finger tip enters into the entry space 4, and an average dielectric constant in the entry space 4 between the conductive layer 50E and the grounded body 11 varies. Consequently, approach of the finger tip of the user is detected as variations in capacitance.

As an application of this system, the fact that the finger tip of the user holds the handgrip body 10 is detected as variations in capacitance, and based on the detected signals, specific signals are emitted from the antenna device with a sensor 1 in the handgrip body 10 at a specific wave length (134 KHz). From a mobile apparatus which receives these signals, the electric wave including an identification signal of the user is emitted again and is received by the antenna attached to the handgrip or other portion of the vehicle body. When the identification of the user is successfully done, the door is unlocked. By setting the door to be locked otherwise, the door cannot be opened easily with the tool other than the original key via the keyhole. In this manner, this system can enhance convenience and safety.

(Application)

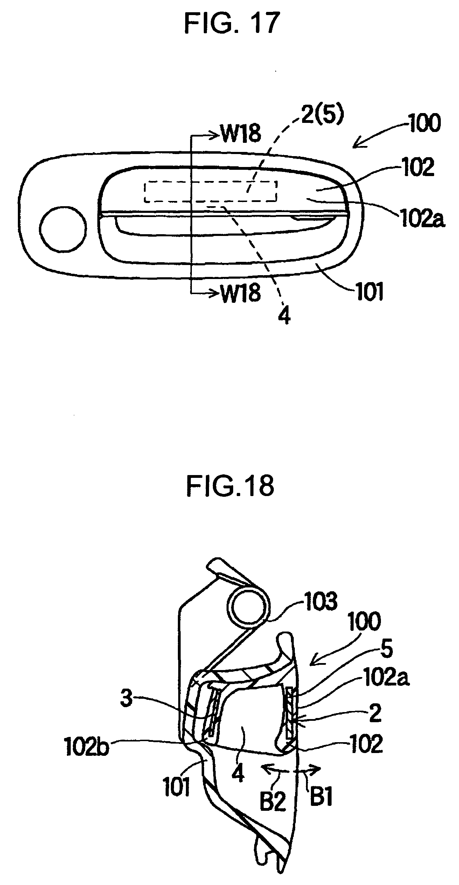

Fig. 17 and Fig. 18 show a first application. The present application shows a case in which the invention is applied to the door handgrip apparatus 100 for opening and closing the door which is mounted to a body of the vehicle. As shown in Fig. 17 and Fig. 18, the door handgrip apparatus 100 includes a base member 101, a handgrip 102 which is provided on the base member 101 so as to be capable of rotating in the directions indicated by arrows B1, B2 and is to be operated by the finger tip of the user, and an urging element 103 for urging the handgrip 102 in the closing direction (direction indicated by the arrow B2). The urging element 103 is formed of a torsion coil spring, but is not limited thereto. The handgrip 102 defines the entry space 4 to which the finger tip is to be entered.

A portion 102a of the handgrip 102 is provided with the aforementioned antenna unit 2. When using, the antenna unit 2 transmits and receives the electric waves for authenticating the ID of the user. The aforementioned opposing member 3 is provided on another portion 102b which opposes the portion 102a of the handgrip 102 via the entry space 4.

Defined between the antenna unit 2 and the opposing member 3 is the entry space 4 to which the finger tip can enter. Therefore, when the finger tip of the user as the object enters into the entry space 4, the capacitance in the entry space 4 varies. Therefore, when the existence of the finger tip in the entry space 4 is determined by variations in capacitance in a state in which the ID is authenticated, the will of the user to open the door is detected. Consequently, the door lock device, not shown, is activated to unlock the door device. As described above, the conditions such as the ID authentication by the antenna unit 2 based on the transmitted and/or received electric wave and detection of the will of the user to open the door based on variations in capacitance are satisfied, the door handgrip apparatus is unlocked. When the door body has conductivity by itself, the opposing member may be formed by the door body while eliminating provision of the opposing member 3 on the portion 102b of the hand grip 102.

(Second Application)

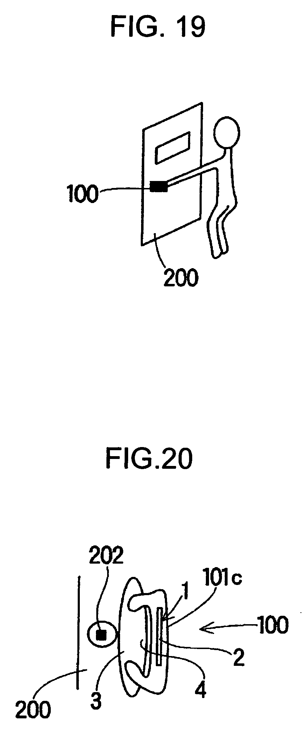

Fig. 19 to Fig. 21 show a second application in which the invention is applied to the door handgrip apparatus 100 for opening and closing a door 200 of the architectural structure. The door handgrip apparatus 100 includes a handgrip 101c to be operated by the finger tip of the user, and the opposing member 3 provided near the handgrip 101c. Defined between the handgrip 101c and the opposing member 3 is the entry space 4 to which the finger tip of the user enters. The handgrip 101c is provided with the antenna device with a sensor 1 having the antenna unit 2 integrated therein. The opposing member 3 having conductivity is grounded via the earth cable, not shown.

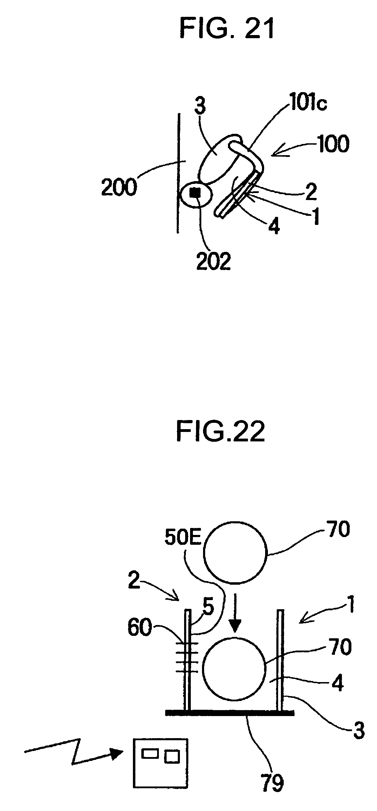

In the example shown in Fig. 21, the door handgrip apparatus 100 includes a rotary handgrip 101c to be operated by the finger tip of the user and the opposing member 3 provided near the handgrip 101c. Defined between the handgrip 101c and the opposing member 3 is the entry space 4 to which the finger tip of the user enters. The handgrip 101c is provided with the antenna device with a sensor 1 having the antenna unit 2 integrated therein. Therefore, when the finger tip of the user as the object enters into the entry space 4, since the capacitance in the entry space 4 varies, the existence of the finger tip is determined, and the will of the user to open the door is detected. Therefore, in this application as well, when the conditions such as the ID authentication by the antenna unit 2 based on the transmission and reception and the detection of the will of the user to open the door based on the variations in capacitance are satisfied, the door lock device not shown is activated to unlock. Reference numeral 202 designates a key hole into which a normal key is inserted. When the door 200 has conductivity, it is also possible to eliminate the plate-shaped opposing member 3 and utilize the door 200 as the opposing member.

(Third Application)

Fig. 22 shows a third application to which the respective embodiments are applied. In this application, the invention is applied to a defective article detection device for judging the quality of the components in the manufacturing factory. As shown in Fig. 22, the antenna device with a sensor 1 includes the antenna unit 2 having the antenna core member 5 with the laminated conductive layer 50E, and the opposing member 3 which is grounded via the earth cable, not shown. The antenna unit 2 and the opposing member 3 define the entry space 4 to which an article to be inspected 70 as the object can pass through. The capacitance when the article to be inspected 70 is a conforming article and this article to be inspected 70 is entered into the entry space 4 is measured in advance. Also, the capacitance when the article to be inspected 70 is a defective article and this article to be inspected 70 is entered into the entry space 4 is estimated in advance. Therefore, when the article to be inspected 70 enters into the entry space 4, the capacitance of the article to be inspected 70 is detected by the antenna unit 2 and the opposing member 3. Depending on the capacitance of the article to be inspected 70 in the entry space 4, whether the article to be inspected 70 is a conforming article or a defective article is determined. When the article to be inspected 70 is a defective article, exit of the entry space 4 is blocked by a blocking element 79 to intercept passage of the article to be inspected 70 to the downstream process. Furthermore, the electric wave is emitted from the antenna unit 2 to notify the receiving side that the article to be inspected 70 is a defective article.

(Fourth Application)

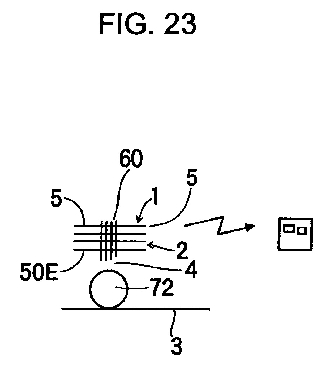

Fig. 23 shows a fourth application of the respective embodiments described above. In this application, the invention is applied to a substance detecting device. As shown in Fig. 23, the antenna device with a sensor 1 includes the antenna unit 2 having the antenna core member 5 with the conductive layer 50E laminated thereon, and the grounded opposing member 3. The antenna unit 2 and the opposing member 3 define the entry space 4 through which a substance 72 as the object can pass. Since the capacitance in the entry space 4 varies when the substance 72 enters into the entry space 4, the entrance of the substance 72 is detected. When the substance 72 is detected, the antenna unit 2 emits the electric wave to notify the receiving side the entry of the substance 72 into the entry space 4. It is also possible to apply the embodiments to a counter device of a system in which the number of the substances entered into the entry space 4 is counted based on the capacitance, and when the number of the substances reaches a predetermined number, the antenna unit 2 emits an electric wave for transmitting the fact that the number of substances reached the predetermined number.

(Others)

The present invention is not limited to the above-described embodiments or the above-described modes. For example, from the above-described statement such that various modifications may be made without departing the scope of the invention, the opposing member 3 must not be necessarily grounded although the opposing member 3 is grounded via the earth cable in the above-described embodiment, the following technical ideas are applicable.

(Additional Claus 1) A defective article detection device including an antenna core member, and a conductive layer disposed on at least part of a surface of the antenna core member, wherein the conductive layer is provided with an antenna device with a sensor as a sensor electrode.

(Additional Clause 2) A substance detection device including an antenna core member, and a conducive layer disposed on at least part of a surface of the antenna core member, wherein the conductive layer includes an antenna device with a sensor as a sensor electrode.

INDUSTRIAL APPLICABILITY

The present invention can be utilized in an antenna device with a sensor, and a door handgrip apparatus. The present invention can be applied to a door of a vehicle such as a motor vehicle or an architectural structure, a defective article detection device, and a substance detection device.

**Claims**

1. An antenna device comprising an antenna unit, the antenna unit comprising an antenna core member having a soft magnetic member and a conductor member attached to the antenna core member, **characterized in that** a conductive layer disposed on at least part of the antenna core member and the conductive layer serves as a sensor electrode.

2. The antenna device according to Claim 1, **characterized in that** the sensor electrode is a capacitance-operated sensor electrode.

3. The antenna device according to Claim 1 or Claim 2, **characterized in that** the antenna core member comprises a soft magnetic member having conductivity, and at least part of the soft magnetic member is the conductive layer.

4. The antenna device according to Claim 3, **characterized in that** the soft magnetic member is formed by laminating a plurality of core sheets.

5. The antenna device according to Claim 3 or Claim 4, **characterized in that** material which forms the soft magnetic member is amorphous soft magnetic material or soft magnetic nanocrystalline material.

6. The antenna device according to Claim 1 or Claim 2, **characterized in that** the antenna core member is formed of ferrite as a base material and the conductive layer is disposed on at least part of a surface of the antenna core member.

7. The antenna device according to Claim 6, **characterized in that** the conductive layer is a film or a foil having conductivity.

8. The antenna device according to any one of Claim 1 to Claim 7, comprising an opposing member provided so as to oppose the conductive layer to define an entry space to which an object can enter between the opposing member and the conductive layer.

9. The antenna device according to Claim 8, **characterized in that** the opposing member is a body of a vehicle body or an architectural structure.

10. The antenna device according to any one of Claim 1 to Claim 9, comprising a controller for transmitting or receiving electrical signals with respect to the conductor member of the antenna unit, and
the controller is set to temporally shift an antenna unit operating time during which the electrical signals with respect to the conductor member are transmitted and received and a sensor operating time during which power is supplied to the sensor electrode at least partly.

11. A door handgrip apparatus comprising: an antenna device including an antenna core member and a conductor member attached to the antenna core member; and
a handgrip for holding the antenna device,
**characterized in that** a conductive layer is disposed on at least part of the antenna core member of the antenna device, and the conductive layer serves as a sensor electrode.

12. The door handgrip apparatus according to Claim 11, **characterized in that** the antenna core member comprises a conductive soft magnetic member and at least part of the soft magnetic member is the conductive layer.

13. The door handgrip apparatus according to Claim 11, **characterized in that** the antenna core member is formed of ferrite as a basic material and the conductive layer is disposed on at least part of a surface of the antenna core member.

# FIG. 1

# FIG.2

# FIG. 3

# FIG.4

# FIG. 5

# FIG.6

# FIG. 7

# FIG.8

## FIG. 9

## FIG.10

## FIG. 11

## FIG.12

# FIG. 13

# FIG.14

# FIG. 15

# FIG.16

# FIG. 17

# FIG.18

# FIG. 19

100

200

# FIG.20

202

1 101c

100

2

200 3 4

# FIG. 21

# FIG.22

FIG. 23

## INTERNATIONAL SEARCH REPORT

| International application No. |
|---|
| PCT/JP2004/005419 |

**A. CLASSIFICATION OF SUBJECT MATTER**
Int.Cl⁷ H01Q1/44, 7/06, 1/32, E05B65/20, B60R25/00

According to International Patent Classification (IPC) or to both national classification and IPC

**B. FIELDS SEARCHED**

Minimum documentation searched (classification system followed by classification symbols)
Int.Cl⁷ H01Q1/44, 7/06-7/08, E05B65/20, B60R25/00

Documentation searched other than minimum documentation to the extent that such documents are included in the fields searched
Jitsuyo Shinan Koho          1922-1996    Toroku Jitsuyo Shinan Koho    1994-2004
Kokai Jitsuyo Shinan Koho     1971-2004    Jitsuyo Shinan Toroku Koho    1996-2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2002-30844 A (Aisin Seiki Co., Ltd.), 31 January, 2002 (31.01.02), Full text; all drawings (Family: none) | 1-13 |
| Y | JP 7-51788 Y2 (TDK Corp.), 22 November, 1995 (22.11.95), Full text; all drawings (Family: none) | 1-13 |
| A | JP 60-233904 A (Matsushita Electric Industrial Co., Ltd.), 20 November, 1985 (20.11.85), Full text; all drawings (Family: none) | 1-13 |

| ☒ Further documents are listed in the continuation of Box C. | ☐ See patent family annex. |
|---|---|

* Special categories of cited documents:
"A"  document defining the general state of the art which is not considered to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search 09 July, 2004 (09.07.04) | Date of mailing of the international search report 27 July, 2004 (27.07.04) |
|---|---|
| Name and mailing address of the ISA/ Japanese Patent Office | Authorized officer |
| Facsimile No. | Telephone No. |

Form PCT/ISA/210 (second sheet) (January 2004)

EP 1 617 509 A1

## INTERNATIONAL SEARCH REPORT

International application No.

PCT/JP2004/005419

C (Continuation). DOCUMENTS CONSIDERED TO BE RELEVANT

| Category* | Citation of document, with indication, where appropriate, of the relevant passages | Relevant to claim No. |
|---|---|---|
| Y | JP 11-280319 A (Fujitsu Ten Ltd.), 12 October, 1999 (12.10.99), Par. No. [0059]; Fig. 8 (Family: none) | 10 |
| A | JP 10-317747 A (Alpha Corp.), 02 December, 1998 (02.12.98), Full text; all drawings (Family: none) | 1-13 |
| A | JP 2-69908 A (Mitsui Petrochemical Industries, Ltd.), 08 March, 1990 (08.03.90), Full text; all drawings (Family: none) | 1-13 |
| A | JP 63-115403 A (Matsushita Research Institute Tokyo, Inc.), 20 May, 1988 (20.05.88), Full text; all drawings (Family: none) | 1-13 |

Form PCT/ISA/210 (continuation of second sheet) (January 2004)